# EUROPEAN PATENT APPLICATION

(11) **EP 2 781 541 A1**
(43) Date of publication of application: **24.09.2014**
(21) Application number: 14160517.0
(22) Date of filing: 18.03.2014
(51) Int. Cl.: C08J 7/12, B29C 59/14

(54) **Sliding member and manufacturing method thereof**

(30) Priority: 19.03.2013 JP 2013056993
(71) Applicant: JTEKT CORPORATION, Osaka-shi Osaka 542-8502 (JP); National University Corporation Nagoya University, Nagoya-shi, Aichi 464-8601 (JP)
(72) Inventor: Suzuki, Masahiro, Osaka-shi,, Osaka 542-8502 (JP); Saito, Toshiyuki, Osaka-shi,, Osaka 542-8502 (JP); Umehara, Noritsugu, Nagoya-shi,, Aichi 464-8601 (JP); Kawara, Shingo, Nagoya-shi,, Aichi 464-8601 (JP); Tokoroyama, Takayuki, Nagoya-shi,, Aichi 464-8601 (JP); Kousaka, Hiroyuki, Nagoya-shi,, Aichi 464-8601 (JP)
(74) Representative: Winter, Brandl, Fürniss, Hübner, Röss, Kaiser, Polte - Partnerschaft mbB

(57) **Abstract**

A sliding member is integrally formed of fluororesin as a whole, and a sliding surface to be slid with a slid member is made hydrophilic. A manufacturing method includes a step of exposing the sliding surface 2 of the sliding member 1 to water plasma 7 generated by Ar gas and vaporized water as raw materials and making the sliding surface 2 hydrophilic.

## Description

### BACKGROUND OF THE INVENTION

The present invention relates to a sliding member formed of fluororesin and a manufacturing method thereof.

To reduce loads to the environment, a shift from lubricating oil to water-based lubricant has been demanded as relates to a sliding member to be slid with a slid member, for example.

However, particularly a sliding member whose sliding surface is formed of fluororesin such as polytetrafluoroethylene (PTFE) has problems that friction torque tends to be increased and seizing tends to occur more easily under an environment in being shifted to water-based lubricant.

It can be conceived as a cause thereof that fluororesin is originally hydrophobic and tends to shed water, so that water-based lubricant is easily excluded from the sliding surface by a slide between the sliding member and the slid member and both members easily come into a non-lubrication and direct-contact state therebetween, and accordingly friction torque tends to be increased and seizing tends to occur more easily.

Japanese Unexamined Patent Application Publication No. JP2000-17091A describes a fluororesin surface being formed into a shape of having multiple needle-like protrusions protruding orthogonal to the surface (a pinholder shape) by ion beam irradiation.

Where the multiple needle-like protrusions are formed on the fluororesin surface, the specific surface area thereof increases and thus an affinity for water-based lubricant of the surface can be improved.

However, the fluororesin surface cannot function sufficiently as a sliding surface because the multiple needle-like protrusions are formed protruding orthogonal to the surface.

That is, friction torque is increased by providing the multiple needle-like protrusions as compared with a flat sliding surface without provision of the needle-like protrusions.

Further, each needle-like protrusion contacts with the slid member at a distal end point and also a load of the slid member is applied mainly to an axial direction of the needle-like protrusion. Therefore, the needle-like protrusion is apt to wear within a short period of time due to sliding with the slid member. With the wear, the specific surface area decreases and the function of holding water-based lubricant on the basis of the affinity is lost. If the function is lost, the water-based lubricant is excluded from the sliding surface by the sliding with the slid member, and both members easily come into a non-lubrication and direct-contact state therebetween. Consequently, friction torque tends to be increased and seizing tends to occur more easily.

Furthermore, the foregoing publication does not discuss at all the application of the fluororesin surface as the sliding surface.

### SUMMARY OF THE INVENTION

An object of the present invention is to provide a sliding member whose sliding surface is formed of fluororesin and friction torque is less apt to be increased and seizing is less apt to occur even if shifted from lubricating oil to water-based lubricant, and a manufacturing method of the sliding member.

In order to achieve the above object, the present invention is a sliding member integrally formed of fluororesin as a whole and having a sliding surface to be slid with a slid member, being characterized in that the sliding surface is made hydrophilic.

According to the present invention, an affinity for water-based lubricant can be improved since the sliding surface is made hydrophilic.

Consequently, excellent lubrication can be secured by the held water-based lubricant if shifted from lubricating oil to water-based lubricant, and friction torque can be less apt to be increased and seizing can be less apt to occur.

The present invention is a manufacturing method of the sliding member of the present invention, characterized by including a step of preparing a sliding member integrally formed of fluororesin as a whole and having a sliding surface to be slid with a slid member, and a step of exposing the sliding surface to water plasma generated by Ar gas and vaporized water as raw materials and making the sliding surface hydrophilic.

According to the present invention, only exposure of the sliding surface to the water plasma generated by Ar gas and vaporized water as raw materials allows the sliding surface to be made hydrophilic. Thus, the manufacturing efficiency of the sliding member of the present invention can be improved.

### BRIEF DESCRIPTION OF DRAWINGS

FIG. 1 is a perspective view showing an example of preferred embodiments of a sliding member of the present invention.
FIG. 2 is an explanatory diagram explaining a step of exposing the sliding surface to water plasma and making the surface hydrophilic in a manufacturing method of the present invention.

### DETAILED DESCRIPTION OF THE INVENTION

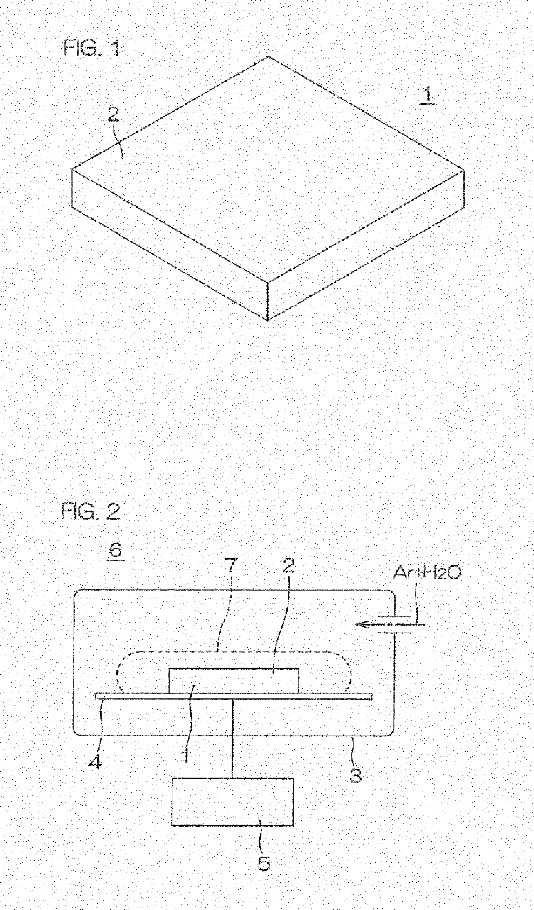

FIG. 1 is a perspective view showing an example of preferred embodiments of a sliding member of the present invention.

Referring to FIG. 1, a sliding member 1 of this example is integrally formed of fluororesin as a whole in a rectangular flat plate shape, and one side of surfaces serves as a sliding surface 2 to be slid with a slid member.

The sliding surface 2 is made hydrophilic, so that an affinity for water-based lubricant can be increased, and excellent lubrication can be secured by the held water-based lubricant if shifted from lubricating oil to water-based lubricant, and friction torque can be less apt to be increased and seizing can be less apt to occur.

Fluororesin to form the sliding member 1 includes, for example, polytetrafluoroethylene (PTFE), tetrafluoroethylene-perfluoroalkylvinylether copolymers (PFA), tetrafluoroethylene-hexafluoropropylene copolymers (FEP),ethylene-fluoroethylene alternating copolymers(ETFE), etc.

The sliding member 1 of the example in the drawing can be manufactured by a manufacturing method of the present invention in which the sliding surface 2 is exposed to water plasma generated by Ar gas and vaporized water as raw materials and made hydrophilic.

FIG. 2 is an explanatory diagram explaining the step of exposing the sliding surface to the water plasma and making the surface hydrophilic in the manufacturing method of the present invention.

Referring to FIG. 2, a plasma treatment apparatus 6 is used, in this step. The plasma treatment apparatus 6 has a holder 4 for holding the sliding member 1 before processing in the vacuum chamber 3, and connects the holder 4 to a high-frequency power source 5.

First, the sliding member 1 is placed with a surface to be made hydrophilic (the sliding surface 2) on the upper side, on the holder 4 provided within the vacuum chamber 3, and in this state, Ar gas and vaporized water are introduced so as to be a corresponding predetermined amount of flow while the vacuum chamber 3 is vacuumed by a vacuum system not shown.

Subsequently, the high-frequency power source 5 is activated in this state to generate water plasma 7 within the vacuum chamber 3.

Then, the sliding surface 2 of the sliding member 1 is exposed to the water plasma 7 and made hydrophilic.

Treatment conditions in this step can be set optionally. To make hydrophilic a sliding surface 2 of a sliding member 1 formed of PTFE, for example, the high frequency output is preferably 15W or higher and preferably 25W or lower on conditions that the amount of flow of Ar is 10 sccm, and the degree of vacuum within the vacuum chamber 3 is 10 to 100 Pa, and preferably 20 to 50 Pa. Further, the treatment time is preferably 10 minutes or longer and preferably 20 minutes or shorter.

To vaporize water, such methods as depressurizing or heating a water-filled container, etc., are employed. The amount of evaporation of water can be stabilized by keeping the container at a constant temperature.

The inflow of the evaporated water is controlled by a needle valve, a mass flow, etc., and the degree of vacuum is adjusted by vacuum rate.

The apparatus of FIG. 2 has a simple structure, and thus, is inexpensive and excellent in versatility.

It is noted that the present invention is not limited to the example of both drawings having been described above.

For example, the configuration of the present invention can be applied to a sliding member having a sliding surface in a given shape.

Moreover, various design changes can be made without departing from the gist of the present invention.

### Example

### <Example 1>

A PTFE plate in the shape of a flat plate having a length of 30 mm, a width of 30 mm, and a height of 5 mm was used as the sliding member 1. The PTFE plate was placed with one side of surfaces thereof (the sliding surface 2) on the upper side, on the holder 4 of the plasma treatment apparatus 6 shown in FIG. 2. After that, following the foregoingprocedure, the sliding surface 2 was exposed to water plasma and made hydrophilic, and the sliding member 1 was manufactured.

Conditions of the treatment were such that the flow of Ar was 10 sccm, the degree of vacuum in the chamber was 20 Pa, the high frequency output was 20W, and the treatment time was 15 minutes.

### <Water Contact Angle Measurement>

Contact angles of the sliding surface 2 before and after the plasma treatment with respect to water were measured. More specifically, a droplet of distilled water was dropped on the sliding surface 2, and a stereoscopic microscope photograph was taken immediately thereafter. The contact angle of the droplet was obtained from the stereoscopic microscope photograph. The results are shown in Table 1.

**Table 1**

| | Pretreatment | Post-treatment |
|---|---|---|
| Contact angle (°) of droplet | 117 | 82 |

From Table 1, it has been determined that the contact angle was made smaller by plasma-treating the sliding surface 2 and the sliding surface 2 was made hydrophilic.

## Claims

1. A sliding member integrally formed of fluororesin as a whole and having a sliding surface to be slid with a slid member, **characterized in that** the sliding surface is made hydrophilic.

2. A manufacturing method of the sliding member of claim 1, **characterizing by** comprising a step of preparing a sliding member integrally formed of fluororesin as a whole and having a sliding surface to be slid with a slid member, and a step of exposing the sliding surface to water plasma generated by Ar gas and vaporized water as raw materials and making the sliding surface hydrophilic.
